Europäisches Patentamt

European Patent Office

Office européen des brevets

(11) Numéro de publication : **0 485 266 A1**

# (12) DEMANDE DE BREVET EUROPEEN

(21) Numéro de dépôt : **91402940.0**

(22) Date de dépôt : **04.11.91**

(51) Int. Cl.$^5$ : **H01J 23/06,** H01J 23/34, H01J 25/04

(30) Priorité : **09.11.90 FR 9013938**

(43) Date de publication de la demande :
**13.05.92 Bulletin 92/20**

(84) Etats contractants désignés :
**DE FR GB IT NL**

(71) Demandeur : **THOMSON TUBES ELECTRONIQUES**
**38, rue Vauthier**
**F-92100 Boulogne-Billancourt (FR)**

(72) Inventeur : **Desmur, Henri**
**THOMSON-CSF, SCPI, Cédex 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**

(54) Canon à électrons modulé par commutation optoélectronique.

(57) Un canon à électrons est modulé par un dispositif de commutation optoélectronique. Le dispositif de commutation comprend une source de lumière modulée (4) et au moins, un commutateur optoélectronique à l'état solide (3), en AsGa ou en Si, ce commutateur (3) étant isolateur en l'absence d'illumination, et conducteur quand illuminé par la source de lumière modulée ; le dispositif comprend également des moyens (5) pour véhiculer la lumière de la source au(x) commutateur(s). Selon une caractéristique, la source de lumière modulée (4) est un laser ; selon une autre caractéristique, la source (4) est une source continue avec modulation externe mécanique ou électrooptique. Selon une caractéristique, le dispositif de commutation optoélectronique est placé entre une source haute tension et la cathode d'un canon à électrons, fournissant ainsi une modulation de la cathode.

Application notamment aux tubes électroniques hyperfréquence.

FIG.2

EP 0 485 266 A1

La présente invention concerne des tubes électroniques hyperfréquence, et plus particulièrement des tubes hyperfréquence fonctionnant en impulsions. De façon plus précise, elle concerne les canons à électrons utilisés dans des tubes.

L'invention est avantageusement utilisée pour obtenir des impulsions très courtes, car elle permet d'obtenir une modulation très forte de courant avec des temps de réponse très courts. L'invention trouvera application également dans d'autres canons à électrons, pour accélérateurs, par exemple.

Il est connu de l'art antérieur d'obtenir une modulation en impulsions de l'énergie hyperfréquence provenant d'un tube électronique de plusieurs façons, parmi lesquelles l'on peut citer la modulation du potentiel de la cathode, la modulation par grille interceptrice ou non, ou encore la modulation par effet photoélectrique à la surface de la cathode.

Les méthodes classiques de modulation par l'application d'une impulsion de haute tension sur la cathode ou d'une tension un peu moindre sur une grille devant la cathode dans un canon à électrons sont limités en fréquence maximale de modulation par la capacité des dispositifs mis sous tension : la cathode, la grille, les conducteurs d'alimentation...

Dans certaines applications des tubes hyperfréquence à impulsions ultracourtes, pour réaliser soit des tubes à structure simplifiée, soit des tubes à rendement d'interaction amélioré et à puissance crête très élevée, l'on cherche à injecter dans le tube un faisceau d'électrons déjà modulé "en paquets" à la fréquence porteuse du signal à amplifier.

Les techniques utilisées pour obtenir ces paquets d'électrons sont décrites par exemple dans un brevet européen 0 181 214 pour l'obtention par un canon à grille spécialement conçu à cet effet, d'une part ; et d'autre part, dans le brevet français 2 599 565 au nom de la demanderesse selon lequel l'émission de paquets est obtenue à partir d'une photocathode éclairée par un laser modulé en amplitude à la fréquence porteuse du signal à amplifier. Ce dispositif s'appelle "lasertron".

Les inconvénients de la modulation par grille sont bien connus de l'homme de l'art, et font l'objet d'améliorations techniques constantes depuis de nombreuses années. Celles-ci concernent surtout les très hautes tensions utilisées généralement dans des canons à électrons de dimensions réduites (notamment entre les différentes électrodes ) ; les courants importants, les fortes capacités entre les différents éléments, la stabilité mécanique sous fortes contraintes thermiques, et la fragilité de l'ensemble.

Les problèmes techniques associés à la mise en oeuvre d'un lasertron sont moins connus car la technique est moins mature, mais l'on peut citer les difficultés d'introduction de la lumière laser à l'intérieur du tube électronique, les conditions d'incidence de la lumière laser sur la photocathode...

Par rapport à ces techniques connues, la présente invention permet d'éviter les inconvénients cités ci-dessus propres à la modulation par grille ou à la lumière laser. A ces fins, l'invention propose d'obtenir la modulation du faisceau électronique provenant d'un canon à électrons, par une nouvelle technique de modulation de l'alimentation de la cathode mettant en oeuvre des dispositifs optoélectroniques permettant des commutations électriques ultra rapides (de l'ordre de quelques picosecondes).

En effet, on connaît depuis quelques années des commutateurs optoélectroniques ultra rapides qui sont constitués d'une pastille semiconductrice optoactive, placée entre deux conducteurs reliés respectivement à la source et à l'utilisation de courant.

La conduction du dispositif est contrôlée et modulable par la densité d'éclairement, dont la longueur d'onde est choisie pour pénétrer dans la masse de la pastille. Par exemple non limitatif, la pastille semiconductrice pourrait être composée de l'arseniure de gallium (AsGa) pour des commutations ultra-rapides, ou encore par le silicium pour des commutations limitées en vitesse au niveau de la microseconde. Dans le cas de l'AsGa, la longueur d'onde de 1,06 micron (dans l'infrarouge), permet de pénétrer à une profondeur de plusieurs millimètres ; cette longueur d'onde est en outre facilement obtenue des lasers à l'état solide couramment proposés dans le commerce.

La profondeur de pénétration de la lumière d'activation est importante car la conduction du dispositif se fait ainsi dans toute la masse éclairée, et donc la résistance de ce commutateur optoélectronique à l'état conducteur est inversement proportionnelle à l'énergie du rayonnement laser éclairant la pastille, ainsi qu'à la mobilité des porteurs. Si, par contre, on utilise un rayonnement à 10,6 microns de longueur d'onde, par exemple, la pénétration du rayonnement et donc la conduction elle-même restent en surface. Cette situation aurait pour résultat des problèmes liés aux pertes ohmiques et à la dissipation de la chaleur générée localement.

La résistance du photoconducteur dans son état passant est proportionnelle au carré de la distance source/drain, et peut avoir une valeur voisine de 1 ohm pour une longueur voisine du millimètre et pour une puissance d'éclairement compatible avec l'utilisation d'une source laser à l'état solide. La résistance peut même être plus faible en régime d'avalanche. L'impédance de la source de courant constituée par l'alimentation HT et les diodes photoconductrices, peut donc être très basse et permettre une modulation rapide de la tension de la cathode.

Par ailleurs, dans son état non conductif, le dispositif peut supporter une tension de quelques kilovolts appliqués aux bornes du commutateur, moyennant des précautions connues de l'homme de l'art. Un tel dispositif est donc capable de commuter directement une puissance relativement élevée.

Quand appliqué, comme proposé dans une caractéristique de la présente invention, à la modulation d'un canon d'électrons d'un tube hyperfréquence, les avantages de la rapidité et précision du commutateur photoélectrique sont conjugués avec la forte puissance hyperfréquence couramment obtenue par les tubes électroniques.

L'objet de l'invention est donc un canon à électrons modulé par un dispositif photoélectrique tel que décrit plus haut ; un autre objet de l'invention est un tube hyperfréquence comportant un tel canon à électrons modulé par des moyens optoélectroniques. L'utilisation d'un commutateur optoélectronique pour moduler le canon à électrons permet d'éviter l'utilisation de photocathodes à l'intérieur de tubes de type lasertron fonctionnant à haute tension, et simplifie les problèmes d'isolement rencontrés dans les tubes à découpage par grille.

A ces fins, l'invention propose un système de canon à électrons modulé en hyperfréquence caractérisé en ce que cette modulation est obtenue par des moyens de commutation optoélectronique commandés optiquement par des moyens de commande, ces moyens de commutation étant reliés en séries dans l'alimentation en haute tension de la cathode, ces moyens de commande comprenant au moins une source de lumière et des moyens de transport de lumière entre la(les)dite(s) source(s) et les moyens de commutation, ces moyens de commutation comprenant un semiconducteur photoélectrique, ce semiconducteur étant conducteur quand suffisamment éclairé par les moyens de commande optique, et isolant en l'absence d'éclairage.

L'invention concerne également des tubes électroniques comprenant un canon à électrons modulé par des moyens de commutation optoélectronique selon l'invention.

D'autres avantages et caractéristiques de l'invention et de sa mise en oeuvre seront mieux comprises à l'aide de l'explication détaillée qui suit, avec ses exemples de réalisation et les dessins ci-annexés dont :

la figure 1 représente schématiquement et en coupe un exemple d'un dispositif de commutation optoélectronique, connu de l'art antérieur ;

la figure 2 représente schématiquement et en plan un exemple de dispositif de modulation de canon à électrons par commutation optoélectronique selon l'invention ;

la figure 3 représente schématiquement en perspective une disposition particulière des commutateurs optoélectroniques dans un dispositif de modulation de canon à électrons selon l'invention, cette disposition permettant de réduire l'induction selfique lors de la conduction du courant ;

la figure 4 représente schématiquement et en coupe longitudinale un exemple de tube électronique comprenant un canon à électrons modulé par commutation optoélectronique selon l'invention ;

la figure 5 représente schématiquement et en coupe longitudinale un autre exemple de tube électronique comprenant un canon à électrons modulé par commutation optoélectronique selon l'invention.

Sur toutes les figures, données à titre d'exemples non limitatifs de réalisations, pour illustrer les principes et quelques applications de l'invention, les mêmes repères désignent les mêmes éléments.

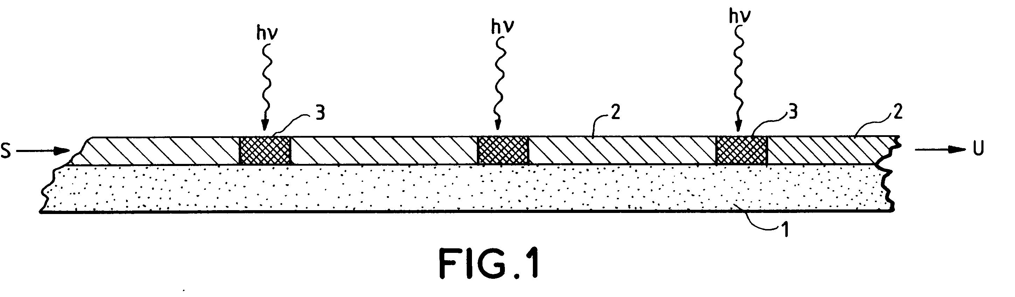

Sur la figure 1, on voit un exemple de dispositif de commutation optoélectronique de conception la plus simple, pour en illustrer le principe de son fonctionnement. Sur un substrat isolant 1, en alumine par exemple, des plots conducteurs 2 sont séparés par des plots 3 en matériau semiconducteur opto-actif, intercalés entre les plots conducteurs 2 et faisant contact électrique à travers des jonctions résistives avec ces derniers. Les plots conducteurs 2 peuvent être réalisés en cuivre, par exemple, et les plots semiconducteurs 3 peuvent être réalisés en AsGa, par exemple, ou encore en silicium, ou en tout autre matière présentant les qualités opto-actives nécessaires pour obtenir l'effet de commutation optoélectronique.

En l'absence d'illumination, les plots 3 en matériau semiconducteur sont isolants, et il n'y a pas de conduction de courant possible entre la source de courant S et l'utilisation de courant U. Avec illumination par des photons h*nu en quantité et d'une énergie suffisante, les plots 3 deviennent conducteurs en avalanche, et le courant peut circuler entre la source S et l'utilisation U. La commutation ainsi obtenue peut être très rapide, inférieur à la picoseconde, et éventuellement jusqu'à la femtoseconde. L'épaisseur de la pastille semiconductrice et la longueur d'onde de l'illumination seront choisis de façon à ce que la pastille devient conductrice dans toute sa masse, donc le commutateur peut véhiculer un courant instantané important, de l'ordre de quelques milliers d'Ampères instantanés. Par exemple pour une épaisseur de la pastille de quelques dixièmes de milimètres, et un volume total de l'ordre d'un milimètre cube, un éclairage par une lumière de longueur d'onde de 1,06 micron permet de rendre la pastille entièrement conductrice.

La lumière laser convient parfaitement pour fournir les photons de la longueur d'onde désirée, et de plus les lasers peuvent être facilement modulés dans des gammes de fréquence très étendues, ce qui en fait des sources idéales de photons pour la réalisation d'un modulateur de canon à électrons. Dans une variante de l'invention, cependant, la lumière peut provenir d'une source continue, telle une lampe à gaz par exemple, et la modulation de la source lumineuse peut être obtenue à l'aide d'un obturateur mécanique ou encore à l'aide d'un dispositif électrooptique telle qu'une cellule de Pockels, par exemple.

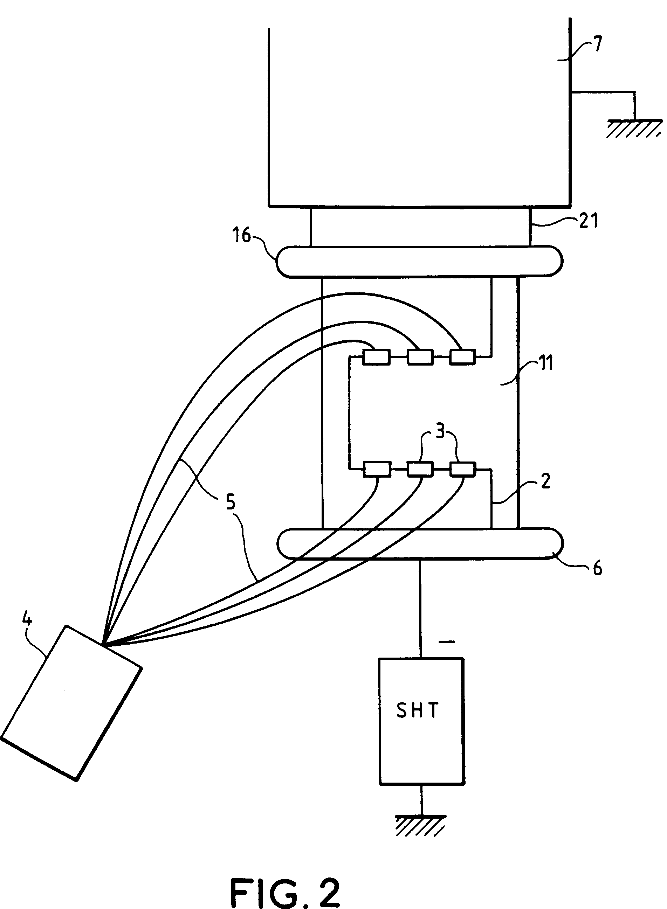

La figure 2 montre schématiquement un détail d'un premier exemple d'une réalisation d'un tube électronique dont le canon à électrons est modulé par un commutateur optoélectronique selon l'invention. Ici on voit une pluralité de commutateurs optoélectroniques 3 sur une piste conductrice 2 disposée entre deux anneaux conducteurs 6, 16. Ces anneaux 6, 16 sont brasés respectivement aux deux extrémités d'un cylindre isolant 11 en alumine, par exemple, selon des méthodes bien connues de l'homme du métier. Un autre cylindre isolant 21 est brasé sur l'anneau 16 à l'une de ses deux extrémités, et à l'autre extrémité est brasé le corps 7 du tube en matériau conducteur, tenu à la masse. Ce corps conducteur 7 tenu à la masse sert également de collecteur d'électrons issus du canon à électrons. Une source haute tension SHT est relié électriquement à l'anneau 6 ; et l'utilisation se trouve relié électriquement à l'anneau 16, à l'intérieur du tube et donc non visible sur ce dessin.

Les commutateurs optoélectroniques 3 sont commandés par la lumière laser provenant d'une source laser 4, et acheminée par des fibres optiques 5. Dans cet exemple d'une réalisation selon l'invention, on a choisi d'illustrer l'utilisation d'un laser YAG pour fournir les photons, mais il est envisageable que la lumière pourrait provenir des sources laser à l'état solide ; dans ce cas, on pourrait imaginer plusieurs sources laser, qui pourraient être rapprochées, voire collées, sur les commutateurs 3 eux-mêmes, donc il n'y aurait plus besoin des fibres optiques pour véhiculer l'énergie lumineuse. Comme mentionné ci-dessus, d'autres sources de lumière sont également envisageables.

Comme dans la figure 1, quand la source laser 4 fournit de la lumière aux commutateurs optoélectroniques 3, ils deviennent conducteurs, et le courant peut passer entre la source haute tension SHT, et l'utilisation (non montrée), qui sera dans cet exemple la cathode d'un canon à électrons.

Dans cet exemple, une pluralité de commutateurs 3 sont montés en série entre la source haute tension SHT et l'utilisation (non montrée), car chaque commutateur peut supporter quelques kilovolts à travers ses bornes dans l'état isolant ; pour l'application servant d'exemple dans cette figure, la cathode est présumée fonctionner à une tension de plusieurs dizaines de kilovolts ; donc une isolation parfaite est aisément obtenue par un nombre suffisant de commutateurs en série. Le dispositif de modulation et de transport de lumière, représenté sur cette figure par le laser 4 et les fibres optiques 5, est conçu pour livrer une puissance lumineuse suffisante à tous les commutateurs en même temps, de façon à ce qu'ils deviennent conducteurs en même temps, et à ce qu'il n'y en ait aucun qui aurait à supporter plus que quelques kilovolts à travers ses bornes.

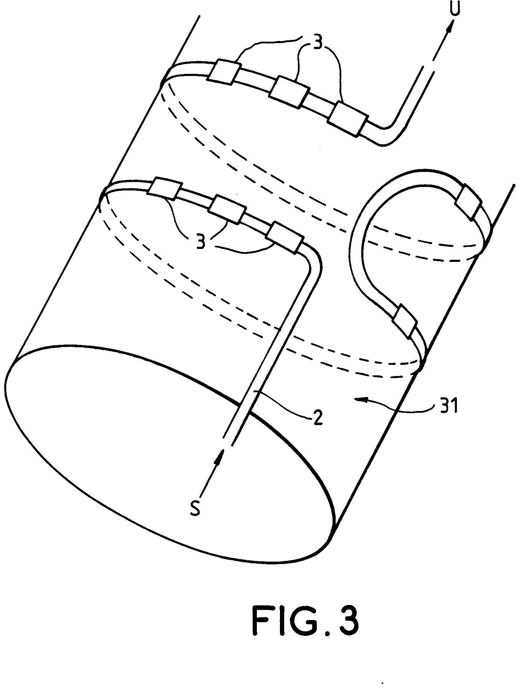

Sur la figure 3, on voit schématiquement une dis-position particulière des commutateurs optoélectroniques 3, connectés en série sur un ruban conducteur 2, faisant presque deux fois le tour de la surface d'un cylindre isolant 31. Afin d'annuler l'induction selfique provenant d'un courant important entre la source du courant S et l'utilisation du courant U, le ruban conducteur fait un tour du cylindre dans le sens des aiguilles d'une montre, puis un tour dans le sens contraire. Le courant étant le même dans les deux tours, le champ magnétique engendré par l'un est égal en amplitude et en sens opposé au champ créé par l'autre tour. La réactance selfique de l'ensemble est ainsi minimisée. D'autres dispositions basées sur les mêmes principes seront facilement réalisables avec un nombre pair de tours, dont la moitié est dans un sens et l'autre moitié dans l'autre sens.

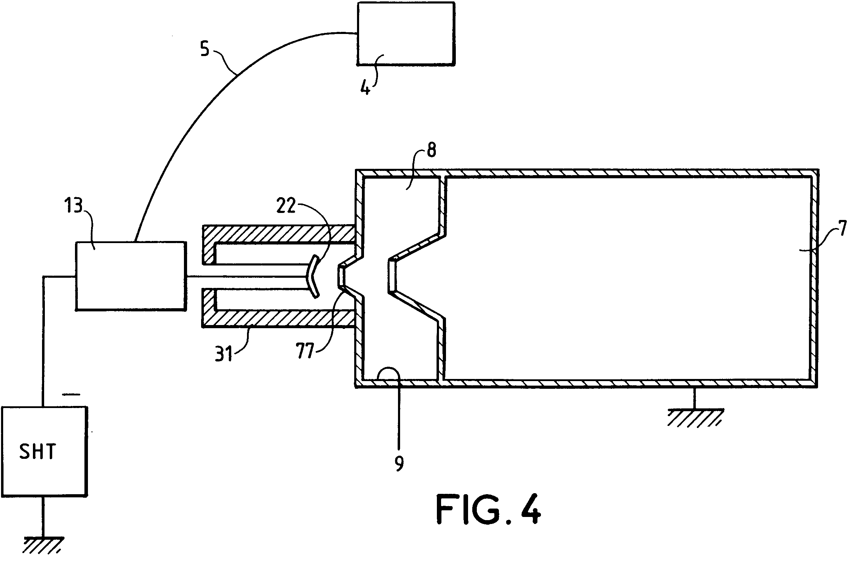

Sur la figure 4, on voit schématiquement et en coupe un exemple de tube électronique comportant un canon à électrons selon l'invention. On voit la source de lumière 4 qui fournit de la lumière modulée par une fibre optique 5 au dispositif de commutation optoélectronique 13, qui agit sur le courant fourni par la source haute tension SHT, modulant ainsi la cathode 22. Les détails du dispositif de la commutation optoélectronique 13 ne sont pas montrés, mais peuvent prendre diverses formes telles qu'exposées ci-dessus, ou encore d'autres formes facilement imaginables par l'homme de l'art à partir de la description faite des principes de l'invention.

Les électrons issus de la surface de la cathode 22 lors d'une impulsion de haute tension négative provenant de la source haute tension SHT et modulée par le dispositif de modulation optoélectronique 13 sont accélérés vers les becs d'anode 77 tenus à la masse, créant ainsi un faisceau électronique modulé qui traverse la cavité résonante 8, et qui vient ensuite se déposer sur les parois internes du collecteur 7. Le passage du faisceau électronique très fortement modulé à travers la cavité résonante produit des champs hyperfréquence intenses dans la cavité ; une partie de l'énergie hyperfréquence peut être prélevée par la boucle de couplage 9 et acheminée vers une utilisation (non montrée). Ainsi, ce dispositif agit comme un amplificateur hyperfréquence, et amplifie le signal de modulation fourni par le laser 4.

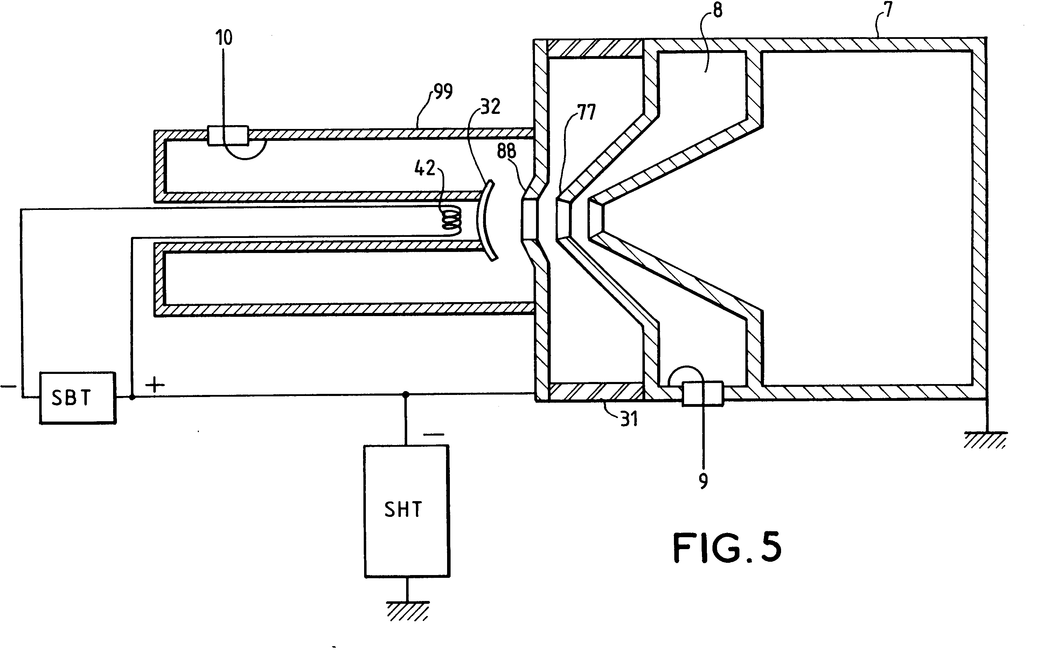

Une autre exemple de l'utilisation d'un canon à électrons modulé par un dispositif de commutation optoélectronique selon l'invention est montré schématiquement et en coupe sur la figure 5. Dans cet exemple, la cathode 32 est chauffée par un filament 42 alimenté par une source basse tension SBT, et l'ensemble du pied haute tension 99, comprenant également la cathode 32 et le Wenhelt 88, est porté à haute tension par la source haute tension SHT. La modulation provenant du dispositif de modulation optoélectronique (non montré) est appliqué à la boucle de couplage 10, créant ainsi un champ hyperfréquence dans l'espace autour de la cathode. Les électrons à la surface de la cathode chaude sont arrachés de la cathode par ce champ fluctuant, créant des paquets d'électrons qui sont ensuite accélérés vers les becs d'anode 77 tenus à la masse. Le cylindre isolant 31 sépare les éléments portés à haute tension des éléments tenus à la masse. Les paquets d'électrons ainsi accélérés forme un faisceau d'électrons fortement modulé, qui traverse la cavité résonante 8 avant de venir se poser sur les parois internes du collecteur 7. L'énergie hyperfréquence des champs électromagnétiques ainsi créés dans la cavité résonante 8 peut être prélevée et acheminée vers une utilisation moyennant la boucle de couplage 9.

## Revendications

1. Canon à électrons à faisceau électronique modulé, comprenant une cathode et au moins une électrode tenue à la masse, caractérisé en ce que la modulation est obtenue par un dispositif de commutation optoélectronique à l'état solide, le dispositif de commutation comprenant une source de lumière modulée, et au moins un commutateur optoélectronique à l'état solide dont l'état conducteur ou non dépend de l'illumination reçue ou non, respectivement, par le commutateur.

2. Canon à électrons selon la revendication 1, caractérisé en ce que ladite source de lumière est un laser.

3. Canon à électrons selon la revendication 1, caractérisé en ce que ladite source de lumière est une lampe à gaz.

4. Canon à électrons selon la revendication 3, caractérisé en ce que ladite source de lumière est modulée par des moyens mécaniques.

5. Canon à électrons selon la revendication 3, caractérisé en ce que ladite source de lumière est modulée par des moyens électrooptiques.

6. Canon à électrons selon la revendication 5, caractérisé en ce que lesdits moyens électrooptiques comprennent une cellule de Pockels.

7. Canon à électrons selon l'une quelconque des revendications 1 à 6, caractérisé en ce que ledit commutateur optoélectronique est de l'arseniure de gallium.

8. Canon à électrons selon l'une quelconque des revendications 1 à 7, caractérisé en ce que ledit commutateur optoélectronique est du silicium.

9. Canon à électrons selon l'une quelconque des revendications 1 à 8, caractérisé en ce que ledit dispositif de commutation comprend une pluralité de commutateurs optoélectroniques connectés en série, tous les commutateurs étant commandés par une seule source de lumière.

10. Canon à électrons selon l'une quelconque des revendications 1 à 8, caractérisé en ce que ledit dispositif de commutation comprend une pluralité de commutateurs optoélectroniques connectés en série, tous les commutateurs étant commandés respectivement par une source de lumière pour chaque commutateur.

11. Canon à électrons selon l'une quelconque des revendications 1 à 10, comprenant un tube électronique, ledit canon à électrons fournissant un faisceau électronique modulé à l'intérieur dudit tube électronique.

12. Canon à électrons selon la revendication 11, caractérisé en ce que ledit tube électronique comporte au moins une cavité résonante et un collecteur d'électrons, et en ce que ledit faisceau électronique modulé est orienté de telle façon à ce qu'il traverse ladite cavité résonante, créant ainsi des champs électromagnétiques hyperfréquence à l'intérieur de ladite cavité résonante.

FIG.1

EP 0 485 266 A1

FIG. 2

FIG.3

FIG. 4

FIG.5

Office européen
des brevets

# RAPPORT DE RECHERCHE EUROPEENNE

Numero de la demande

EP   91 40 2940

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 384 813 (THOMSON TUBES ELECTRONIQUES) | 1-8,11, 12 | H01J23/06 |
| A | | 9 | H01J23/34 |
| | * abrégé * | | H01J25/04 |
| | * colonne 1, ligne 1 - colonne 2, ligne 10 * | | |
| | * colonne 4, ligne 52 - colonne 5, ligne 17 * | | |
| | * colonne 5, ligne 51 - ligne 57 * | | |
| | --- | | |
| Y | GB-A-948 875 (SIEMENS & HALSKE AKTIENGESELLSCHAFT) | 1-8,11, 12 | |
| | * page 1, ligne 19 - ligne 35; figure * | | |
| | * page 2, ligne 3 - ligne 28 * | | |
| | --- | | |
| Y,D | EP-A-0 251 830 (THOMSON-CSF) | 1,2,7,8, 11,12 | |
| A,D | | 9,10 | |
| | * abrégé * | | |
| | --- | | |
| Y | GB-A-2 157 846 (BICC PUBLIC LIMITED COMPANY) | 1,3,4 | |
| | * abrégé * | | |
| | * page 1, ligne 53 - ligne 57 * | | DOMAINES TECHNIQUES RECHERCHES (Int. Cl.5) |
| | * page 1, ligne 72 - ligne 76 * | | |
| | --- | | |
| Y | PATENT ABSTRACTS OF JAPAN vol. 12, no. 207 (E-621)14 Juin 1988 & JP-A-63 004 676 ( MATSUSHITA ELECTRIC IND CO LTD ) 9 Janvier 1988 * abrégé * | 1-7 | H01J |
| | --- | | |
| Y | PATENT ABSTRACTS OF JAPAN vol. 10, no. 143 (P-459)27 Mai 1986 & JP-A-60 263 121 ( RICOH KK ) 26 Décembre 1985 * abrégé * | 1-8 | |
| | ----- | | |

Le présent rapport a été établi pour toutes les revendications

| Lieu de la recherche | Date d'achèvement de la recherche | Examinateur |
|---|---|---|
| LA HAYE | 17 JANVIER 1992 | MARTIN Y VICENTE M. |